# EUROPEAN PATENT APPLICATION

(11) **EP 0 574 815 A1**
(43) Date of publication of application: **22.12.1993**
(21) Application number: 93109239.9
(22) Date of filing: 09.06.1993
(51) Int. Cl.: H02P 7/00, H03K 17/66, H03K 17/687

(54) **Bi-directional load current drive circuit**

(30) Priority: 18.06.1992 US 900409
(71) Applicant: EASTMAN KODAK COMPANY, Rochester, New York 14650-2201 (US)
(72) Inventor: Stephany, Thomas M., c/o Eastman Kodak Company, Rochester, New York 14650-2201 (US)
(74) Representative: Schmidt, Peter, Dipl.-Ing.

(57) **Abstract**

Bi-directional load current drive circuit of the H-bridge type in which current drive switching components (Q1-Q3, Q2-Q4) in opposite legs (11,12) of the H-drive circuit are simultaneously driven into conduction by means of a single drive control component (Q5,Q6) thereby providing a simplified two-channel control of the load current drive circuit.

## Description

### Field of the Invention

This invention relates to the field of bi-directional drive current circuit of the H-bridge type in which drive current is selectively driven in either a forward or reverse direction through a common load means. More specifically, it relates to novel control of the bi-directional flow of drive current in such a circuit.

### Background of the Invention

Bi-directional current drive circuits of the H-bridge type are well known; examples of which are shown in US Patents 4,581,565 and 4,550,992. In general, an H-bridge circuit typically is provided with four transistors serially connected in two parallel paths between a source voltage and a reference potential such as ground. A load, such as a motor drive winding or a camera shutter drive coil, is connected between the common transistor terminal connections of the two transistors in each path thus forming, schematically, something of an H-shaped configuration. By appropriately controlling conduction of the transistors, such that an upper transistor in one path is combined with a lower transistor in the other path and visa-versa, current in the load can be controlled to flow in either direction, i.e. forward or reverse, as needed.

A difficulty with the circuits for controlling conduction of the current drive transistors in the desired manner lies in the need for a four channel control input to separately control each of the current drive transistors. This is illustrated in the above mentioned '992 patent wherein the base terminal of the current drive transistors are independently controlled by four separate multi-transistor control circuits which are, in turn, controlled by logic circuits separate from the H-bridge drive circuit. Such drive control arrangements are costly and increase the size of both discrete circuit and integrated circuit drive assemblies. It is desirable to provide a simplified drive control arrangement to reduce the cost and size of the circuit assembly and also to conserve silicon area in an integrated circuit design which would reduce the cost and power consumption requirement of the IC. The latter is particularly important in certain applications, such as in a camera.

### Summary of the Invention

In accordance with the invention, therefore, there is provided a bi-directional load current drive circuit of the type having first and second circuit legs coupled in parallel across a voltage source, the circuit legs each having a load current source transistor and a load current sink transistor coupled in series with a common terminal between the source and sink transistors of each leg, the terminals being adapted for connection to opposite sides of a common load element conductively coupled between each circuit leg. In the drive circuit, each of the source and sink transistors have a control terminal adapted to control load current conduction through its respective transistor. In particular accord with the invention, the drive circuit is characterized by the provision of first and second input terminals for supplying, respectively, a first input control signal to control load current conduction in the forward direction through the load element and a second input control signal to control load current conduction in the reverse direction through the load element. The drive circuit of the invention is further characterized by provision of first and second input drive control transistors, each of which is mutually exclusively coupled to one of the input control signal supply terminals and to the current conduction control terminals of a source transistor and a sink transistor in opposite legs of the load current drive circuit, each of the drive control transistors being responsive to an input signal at its respective input terminal for simultaneously controlling conduction of its respective source and sink transistors in opposite circuit legs whereby forward and reverse drive current conduction through the load element is independently controlled by one of only two input control signals.

### Brief Description of the Drawings

In the drawings:
Fig. 1 is a schematic diagram of a bi-directional load current drive circuit embodying the present invention.
Fig. 2 is a schematic diagram of an alternative embodiment of the load current drive circuit of the present invention.

### Detailed Description of the Invention

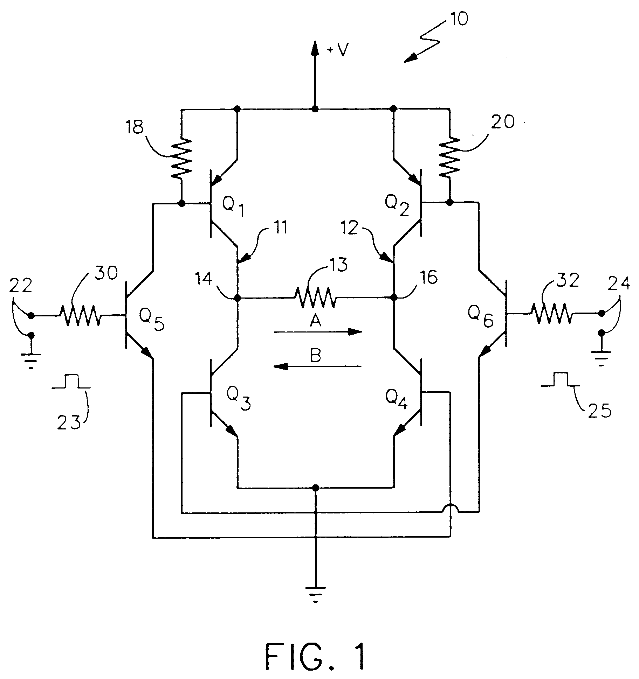

Referring to Fig. 1, A load current drive circuit according to the invention is comprised of first and second circuit legs 11 and 12. Circuit leg 11 includes a load current source transistor Q1 and a load current sink transistor Q3 serially coupled in a path between an operating potential source +V and ground. Similarly, the opposite circuit leg 12 includes a load current source transistor Q2 and a load current sink transistor Q4 coupled in series between potential source +V and ground. A first load current output terminal 14 at the common connection between the collector of PNP transistor Q1 and the collector of NPN transistor Q3 and a second load current output terminal 16 at the common connection between PNP transistor Q2 and the collector of NPN transistor Q4 are adapted to be coupled to opposite sides of an external load element 13. Resistors 18 and 20 comprise biasing means coupled from potential +V across the emitter-base junctions of drive current source transistors Q1 and Q2, respectively, to hold these transistors normally in the non-conducting state. First and second input terminals 22 and 24 are provided for supplying, respectively, a first input control signal 23 to control load current conduction through load element 13 in a first, or forward, direction shown by arrow A and a second input control signal 25 to control load current conduction in a second, or reverse, direction shown by arrow B. First and second input drive control transistors is comprised of transistors Q5 and Q6, each of which is mutually exclusively coupled to one of said input control signal supply terminals and to the current conduction control terminals of a source transistor and a sink transistor in opposite legs of the load current drive circuit 10. To this end, NPN transistor Q5 has its base coupled via an input coupling resistor 30 to input terminals 22. The collector of transistor Q5 is coupled to the base of source transistor Q1 in circuit leg 11 while the emitter of transistor Q5 is coupled to the base of sink transistor Q4 in the opposite circuit leg 12. Similarly, NPN transistor Q6 has its collector coupled to the base of source transistor Q2 in circuit leg 12 and its emitter coupled to the base terminal of sink transistor Q3 in the opposite circuit leg 11. With this arrangement, an "on" signal, i.e. a high-going signal, at either of input terminals 22 or 24 will cause the corresponding control transistor Q5 or Q6 to simultaneously force the source transistor and sink transistor (Q1, Q4, in the case of transistor Q5 and Q2, Q3 in the case of transistor Q6) to begin conducting load current while a low input control simultaneously stops the load current conduction. Thus one of only two input control signals 23 and 25 is able to independently control the forward or reverse drive current through load 13, as desired.

In the operation of the exemplary embodiment of Fig. 1, since current source transistors Q1 and Q2 are PNP transistors which are forced into conduction by a low signal at their respective bases, and since input control transistors Q5 and Q6 are normally non-conductive in the absence of any "on" signals at terminals 22 and 24, resistors 18 and 20, being coupled to positive voltage source +V, function to hold the bases of transistors Q1 and Q2 in a high condition preventing any false triggering of these current source transistors into conduction.

To initiate conduction of current through load 13 in the direction of arrow A, a current control input signal in the form of a positive voltage at input terminals 22 is coupled via resistor 30 to the base of control transistor Q5. The resulting current through the base-emitter junction drives transistor Q5 into conduction and at the same time forces base-emitter current conduction in sink transistor Q4 which disposes transistor Q4 to turn on, i.e. enable collector-emitter current conduction. As transistor Q5 goes into conduction, the resulting Q5 collector-emitter current through resistor 18 draws the base of drive current source transistor Q1 low thus forcing Q1 into conduction simultaneous with the turn-on of sink transistor Q4. Thus control transistor Q5 functions to turn on source transistor Q1 and sink transistor Q4 simultaneously thus completing a circuit path for drive current to flow in the direction of arrow A though load element 13. In a similar manner, to force drive current through load 13 in the reverse direction, in the direction of arrow B, the high signal is removed from input terminals 22 and a high signal 25 applied to input terminals 24 driving control transistor Q6 into conduction. As can be seen from the previous description, the conduction of transistor Q6 simultaneously forces current source transistor Q2 and sink transistor Q3 into conduction thus completing the reverse current path through load 13 as shown by arrow B.

It will be appreciated by those skilled in the art, that while a particular set of transistor polarities is illustrated, the transistor types may be interchanged in a manner well known to transistor circuit designers with appropriate change of biasing potentials and the same benefits of simple control of the current drive circuit maintained.

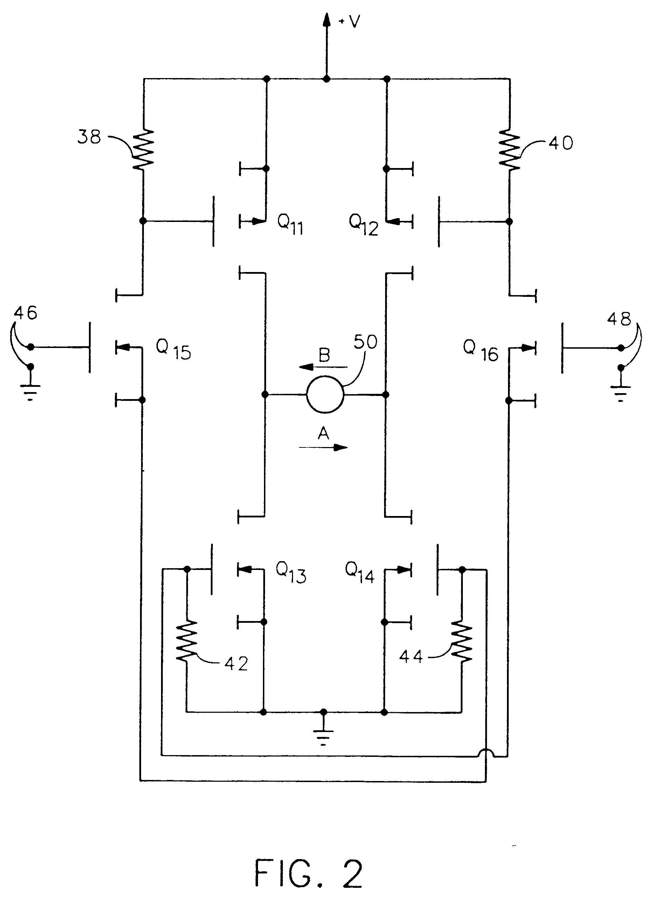

Referring to Fig. 2, an alternative bi-directional load current drive circuit of the invention is shown implemented in a MOSFET configuration. In this circuit, MOSFET transistors Q11-Q16 correspond functionally to transistors Q1-Q6 of Fig. 1. Resistors 38 and 40 functionally correspond to biasing resistors 18 and 20 of Fig. 1. Thus transistors Q11 and Q12 function as the current source transistors and Q13 and Q14 as the sink transistors. The drain terminal of drive control transistor Q15 is coupled to the gate terminal of source transistor Q11 while the Q15 source terminal is coupled to the gate of sink transistor Q14 in the opposite circuit leg. Similarly, the drain terminal of transistor Q16 is coupled to the gate terminal of source transistor Q12 in one circuit leg and the source terminal to the gate of sink transistor Q13 in the opposite circuit leg. Resistors 38 and 40 serve as biasing means to hold source transistors Q11 and Q12 in the normally nonconducting condition and resistors 42 and 44 function to provide biasing means for transistors Q13 and Q14 to enable load current conduction simultaneously with their respective source transistors. A positive-going "on" signal applied via input terminals 46 drives control transistor Q15 into conduction. By suitable choice of the values of resistors 38 and 44 in a manner well known in the art, the source and sink transistors Q11 and Q14 are simultaneously caused to conduct thus initiating load current in the direction of arrow A through load element 50. To reverse the direction of load current, the input "on" signal is removed from input terminals 46 and an "on" signal is applied to input terminals 48 to simultaneously begin conduction in transistors Q12 and Q13 to cause load current to flow in the reverse direction of arrow B through load element 50.

It will be appreciated that what has been described is a bi-directional load current drive circuit of novel construction that provides the advantage of simplified control with a minimum of drive components and which is correspondingly low in cost. The invention has thus been described in detail with particular reference to presently preferred embodiments, but it will be understood that variations and modifications can be effected within the scope of the invention as set forth in the following claims.

## Claims

1. A bi-directional load current drive circuit having first and second circuit legs (11,12) coupled in parallel across a voltage source, the circuit legs each having a load current source transistor (Q1,Q2) and a load current sink transistor (Q3,Q4) coupled in series with a common terminal (14,16) between the source and sink transistors of each leg being adapted for connection to opposite sides of a common load element (13) conductively coupled between each circuit leg, each of the source and sink transistors having a control terminal adapted to control load current conduction through its respective transistor; the load current drive circuit comprising:
first and second input terminals (22,24) for supplying, respectively, a first input control signal (23) to control load current conduction in the forward direction (A) through said load element (13) and a second input control signal (25) to control load current conduction in the reverse direction (B) through said load element (13); and
first and second input drive control transistors (Q5,Q6), each of which is mutually exclusively coupled to one of said input control signal supply terminals (22,24) and to the current conduction control terminals of a source transistor (Q1,Q2) and a sink transistor (Q3,Q4) in opposite legs (11,12) of the load current drive circuit, each of said drive control transistors being responsive to an input signal at its respective input terminal for simultaneously controlling conduction of its respective source and sink transistors in opposite circuit legs whereby forward and reverse drive current conduction through said load element is independently controlled by one of only two input control signals.

2. The load current drive circuit of claim 1 further comprising biasing means coupled to the current conduction control terminal of the source transistor in each circuit leg for independently biasing the source transistor to a normally nonconducting state, the input drive control transistors each being coupled to the biasing means of its respective current source transistor and being adapted to remove the bias in response to an input control signal, whereby load current conduction is initiated in its respective load current source and sink drive transistors.

3. The load current drive circuit of claim 1 in which said transistors Q1-Q6 are bipolar transistors.

4. The load current drive circuit of claim 3 in which said source transistors are of a first conductivity type and said drive control and sink transistors are of opposite conductivity type to the source transistors.

5. The load current drive circuit of claim 1 in which said transistors Q11-Q14 are field effect transistors.

6. The load current drive circuit of claim 5 wherein the current conduction control terminals of the source (Q11,Q12) and sink (Q13,Q14) transistors are gate terminals and said drive circuit further includes means (38,40) coupled to the source transistor gate terminals for biasing the source transistors to a normally non-conducting state and means (42,44) coupled to the sink transistor gate terminals for enabling conduction of said sink transistors when said source transistor conduction occurs; and said drive control transistors (Q15,Q16) are each coupled to the biasing means of a source and sink transistor in opposite circuit legs whereby an input control signal causes a drive control transistor to simultaneously enable conduction in said opposite leg source and sink transistors.
